# EUROPEAN PATENT APPLICATION

(11) **EP 4 791 130 A1**
(43) Date of publication of application: **12.08.2026**
(21) Application number: 25157140.2
(22) Date of filing: 11.02.2025
(51) Int. Cl.: H05K 7/20

(54) **A COOLING PLATE FOR TEMPERING AT LEAST ONE COMPUTING UNIT OF AN ELECTRONIC COMPUTING DEVICE, AN ARRANGEMENT, A CALCULATING UNIT, AS WELL AS AN ELECTRONIC COMPUTING DEVICE**

(71) Applicant: Connaught Electronics Ltd., County Galway H54 Y276 (IE)
(72) Inventor: WUJANICZ, Stefan, Tuam, H54 Y276 (IE); CAKIR, Erim, Tuam, H54 Y276 (IE); RAJASEKAR, Solomonraj, 600130 Chennai, Tamil Nadu (IN)
(74) Representative: Jauregui Urbahn, Kristian

(57) **Abstract**

A cooling plate (10) for tempering at least one computing unit (7, 8, 9, 35, 36) of an electronic computing device (3), comprising at least a first cooling plate element (16), which comprises a first cavity (20) for receiving a fluid from a temperature control unit (37) of the electronic computing device (3), wherein the first cooling plate element (16) is plate-like formed and comprises a first side (11) for arranging a first computing unit (7) and a second side (12), which is arranged opposite to the first side (11), for arranging a second computing unit (8), wherein the cooling plate (10) comprises a second cooling plate element (17), wherein the second cooling plate element (17) comprises a second cavity (21) for receiving a fluid from a temperature control unit (37), wherein the second cooling plate element (17) is plate-like formed, wherein the second cooling plate element (17) comprises at least a third side (13) for arranging a third computing unit (9), and wherein the second cooling plate element (17) is arranged at right angles to the first cooling plate element (16). Furthermore, the present invention relates to an arrangement (5), to a calculating unit (6), to an electronic computing device (10), and to a motor vehicle (1).

## Description

The present invention relates to a cooling plate for tempering at least one computing unit of an electronic computing device according to the pending claim 1. Furthermore, the present invention relates to a corresponding arrangement, to a corresponding calculating unit, as well as to a corresponding electronic computing device.

In the automotive industry, particularly in the context of autonomous driving, the so-called electronic control unit (ECU), which may also be regarded as an electronic computing device, plays a critical role in controlling and managing various vehicle systems and functions. With increasing levels of autonomy, ECUs are becoming more complex and powerful, leading to higher thermal loads and cooling requirements. To ensure reliable operation and longevity of the ECUs, effective cooling is essential. There are several cooling methods used in the automotive industry, including air-cooling, liquid cooling, and hybrid cooling systems.

Air-cooling is a simple and cost-effective method that relies on natural convection or forced airflow to dissipate heat from the ECU. However, as the power density of ECUs increases, air-cooling may not be sufficient to meet the thermal management requirements.

Liquid cooling is a more efficient method that uses a cooling fluid to transfer heat away from the ECU. Liquid cooling can provide higher cooling capacity and better temperature control compared to air-cooling. However, liquid cooling systems are typically more complex and expensive than air-cooling systems.

Hybrid cooling systems combine the advantages of both air and liquid cooling methods. These systems use a combination of forced air and liquid cooling to provide efficient and flexible thermal management of ECUs.

Hybrid cooling systems can be optimized to meet the specific cooling requirements of different ECU designs and applications.

In the context of autonomous driving, effective cooling of ECUs is particularly important due to the increased complexity and power density of these systems. Autonomous driving functions require high-performance sensors, processors, and algorithms that generate significant heat loads. Additionally, autonomous vehicles may operate in challenging thermal environment, such as hot or cold weather conditions, which can further increase the cooling requirements.

To address these challenges, automotive manufacturers and suppliers are developing advanced cooling solutions for the ECUs in autonomous driving systems. These solutions include high-performance liquid cooling systems, thermoelectric coolers, and novel materials with enhanced thermal properties. By leveraging these advances in cooling technology, the automotive industry can ensure reliable operation and longevity of ECUs in autonomous driving systems, enabling safer and more efficient transportation for everyone.

In many electronic computing devices, in particular used in the automotive industry, multiple printed circuit boards (PCB) are often integrated into a single unit, in particular in a single electronic computing device, to reduce size and complexity. When these PCBs generate heat, effective thermal management becomes critical to ensure reliable operation and longevity of the system. As already mentioned, these PCB can also be cooled with various systems, such as air-cooling, liquid cooling, or hybrid cooling. To cool multiple PCBs within an ECU, it is important to ensure that the thermal interface between the PCBs, in particular the so called cooling plate, is optimized. This can be achieved through various techniques, such as, for example, using thermal interface materials, low thermal resistance, ensuring proper mechanical mounting and alignment, and minimizing gaps and voids between the PCB and the cooling solution. Furthermore, in addition to the cooling methods, there may be design considerations for the ECUs with multiple PCBs, such as layout optimization, power distribution, and signal distribution. By addressing these considerations in conjunction with thermal management, ECU designers may ensure reliable operation and longevity of the system while meeting size, weight, and cost constraints.

Therefore, there is a need in the art to provide a cooling plate, which is capable of a cooling a plurality of PCBs, in particular at least three PCBs, in an improved manner and with a low usage of construction space.

Therefore, it is an object of the present invention to provide a cooling plate, a corresponding arrangement, a corresponding calculating unit, as well as a corresponding electronic computing device, by which the disadvantages of the state of the art are overcome.

In particular, it is an object of the present invention to provide a cooling plate, an arrangement, a calculating unit, as well as an electronic computing device, by which a more efficient cooling of a plurality of PCBs/computing units inside of the electronic computing device can be provided.

This object is solved by a cooling plate, a corresponding arrangement, a corresponding calculating unit, as well as a corresponding electronic computing device according to the independent claims. Advantageous embodiments are presented in the dependent claims.

One aspect of the invention relates to a cooling plate for tempering at least one computing unit of an electronic computing device, comprising at least a first cooling plate element, which comprises a first cavity for receiving a fluid from a temperature control unit of the electronic computing device, wherein the first cooling plate element is plate-like formed and comprises a first side for arranging a first computing unit and a second side, which is arranged opposite to the first side, for arranging a second computing unit.

According to an embodiment, the cooling plate comprises a second cooling plate element, wherein the second cooling plate element comprises a second cavity for receiving a fluid from a temperature control unit, wherein the second cooling plate element is plate-like formed, wherein the second cooling element comprises at least a third side for arranging a third computing unit, and wherein the second cooling plate is arranged at right angles to the first cooling plate element.

Therefore, a cooling plate can be provided, which is in particular T-shape formed, and therefore comprises at least three sides, on which different computing units can be arranged. It is obvious for a person skilled in the art, that the cooling plate may also be used with just one computing unit, just two computing units, or at least three computing units, but may comprise the capability for at least three computing units.

According to the T-shape form, it is also possible, to arrange a fourth computing unit on a fourth side of the second cooling plate element and/or a fifth computing unit on the fourth side of the second cooling plate element.

In particular, according to the state of the art, conventional liquid cooling plates can only cool one or two computing units, which may be in particular the so-called PCBs, at the same time. However, in some embodiments, more than two PCBs are used and need to be cooled. The invention proposes in particular a T-shaped cooling plate to cool multiple PCBs, at least three, at once.

The cooling plate, according to the invention, has the ability to provide liquid cooling for, in particular, at least three, four, or five computing units with one cooling plate. It is more compact than, for example, a triangular cooling core solution. Furthermore, better thermal efficiency is provided as a more sophisticated design is possible compared to a triangular cooling core. The cooling plate is machinable or castable with two welded plates for closing channels. Furthermore, the possibility to implement heat dissipating features, such as fins, pins, turbulators, and so on is provided. A triangular cooling core does not allow for that due to design and manufacturing limitations.

In particular, the electronic computing device may be configured for an at least in part autonomous operation of a motor vehicle or a fully autonomous operation of the motor vehicle. In particular, the electronic computinge devices/electronic control units (ECUs), used in autonomous driving systems, are highly complex and powerful, generating higher thermal loads and requiring more advanced cooling solutions. The cooling requirements for ECUs in autonomous driving systems depend on different factors, including the power density of the components, the thermal budget of the system, and the operating conditions. One of the main challenges in cooling the ECUs for autonomous driving is the high power density of the components used, such as sensors, processors, and algorithms that generate significant heat loads, and which may regarded as so called power elements. These components are often integrated into a small form factor, which limits the availability space for cooling solutions. Additionally, autonomous vehicles may operate in challenging thermal environments such as hot or cold weather conditions, further increasing the cooling requirements. Therefore, there is a need for a high cooling capacity, a precise temperature control, a fast response time, a compact size and a low weight, low noise, and the compatibility with automotive standards. The cooling plate, according to the invention, fulfill all of these objects.

In particular, to meet all these requirements, liquid cooling solutions are often used in the ECUs for autonomous driving. These solutions use cooling fluids to transfer heat away from the components, providing efficient and effective cooling.

With the "cooling plate", also a heating of the ECU can be provided. In particular, in some certain situations, the computing units need to be heated to ensure proper operation. For example, in cold weather conditions, where the low ambient temperatures can cause the components of the computing units to become too cold, leading to reduced performance or even failure. In this case, heating of the computing unit may also help its operating temperature and prevent condensation from forming on the electronic components, which could lead to corrosion and other issues. Therefore, one main object of the invention is to cool the computing units, but in some conditions, it is also possible to heat the computing units.

According to an embodiment, the second cooling plate comprises a middle area in the middle of a fourth side of the second cooling plate, wherein the fourth side is arranged opposite to the third side, wherein the first cooling plate and the second cooling plate are connected at the middle area. Therefore, an in particular a T-shaped cooling plate can be provided. The T-shaped cooling plate is able to carry at least three computing units, in particular, also a fourth computing unit as well as a fifth computing unit. Therefore, a plurality of computing units can be arranged on just one cooling plate.

In another embodiment, the cooling plate comprises one fluid inlet and one fluid outlet for providing the fluid for the first cooling plate element and the second cooling plate element. Therefore, just one temperature control unit may be used and just one inlet and outlet is used. In particular, the first cooling plate element and the second cooling plate element are therefore fluidically connected to each other. It is operative for a person skilled in the art, that also each of the cooling plate elements may comprise a respective inlet and a respective outlet. It is also possible, that two temperature control units are used, wherein a temperature control unit is used for each of the cooling plate elements.

In another embodiment, the first cavity and the second cavity are fluidically connected to each other. Therefore, the fluid of the temperature control unit can, for example, be provided with just one inlet, transmitted from the first cavity to the second cavity or vice versa, and then transmitted back via the outlet to the temperature control unit.

In another embodiment, the second cooling plate comprises a first opening in the middle area for providing the fluid to the first cavity and a second opening for receiving the fluid from the first cavity. For example, the inlet of the temperature control unit is arranged at a side part of the second cooling plate element. Then, the fluid is directed, at least in part, through the second cooling plate element until it reaches the first opening. The first opening then transmits the fluid to the first cooling plate element. The fluid then travels through the first cooling plate element until it reaches the connection between the first cooling plate element and the second cooling plate element, which is in particular the second opening in the second cooling plate element. From the second opening, the fluid is then traveling again through the second cooling plate element until the outlet, which is for example, also at a side part of the second cooling plate element. Therefore, an easy way for providing the fluid for the first cooling plate element and the second cooling plate element is provided.

In another embodiment, at least in one cavity of the two cavities, at least one fluid guiding element is arranged. Therefore, a reliable flow of the fluid through the first cooling plate element and/or the second cooling plate element can be provided with the fluid guide element. In particular, a plurality of fluid guide elements are arranged inside the first cooling plate element and/or the second cooling plate element. Therefore, an improved heat dissipation can be provided.

In another embodiment, the at least one fluid guide element is at least in part meander-shaped arranged inside the cavity. Therefore, the fluid can be guided in a meander-shaped form through the cooling plate elements. Therefore, the heat dissipation is improved.

In another embodiment, at least in one cavity of the two cavities, at least one surface enlargement element is arranged. The surface enlargement element is in particular in a connection with a housing of the cooling plate elements. Therefore, a heat dissipation through the surface enlargement element is provided and therefore an improved heat dissipation to the fluid is provided.

In another embodiment, the at least one surface enlargement element has a fin-like structure. The fin-like structure has the advantage that the surface is enlarged and it builds not much resistance for the flow of the fluid. Therefore, an improved heat dissipation is provided.

In another embodiment, the at least one surface enlargement element has a pole-like structure. The pole-like structure has the advantage that the surface is enlarged and it builds not much resistance for the flow of the fluid. Therefore, an improved heat dissipation is provided.

In another embodiment, at least the first side of the first cooling plate element comprises at least one pedestal for being thermally connected to a power element of the first computing unit. In particular, a plurality of pedestals are provided on the first side. Furthermore, in particular, at least one, in particular, a plurality of pedestals are also provided on the second side, as well as on the third side and potentially on the fourth side. In particular, the pedestals are arranged where the cooling plate is in contact with a power element of the computing unit. Therefore, the thermal energy from the power unit can be dissipated in an improved manner.

Another aspect of the invention relates to an arrangement for tempering at least one computing unit of an electronic computing device, comprising at least a cooling plate according to the preceding aspect and at least one temperature control unit. The temperature control unit is in particular configured as a cooling circuit.

As already mentioned, the temperature control unit is in particular configured as a so-called liquid cooling circuit, which typically involves several components that work together to efficiently remove the heat from the computing units and dissipate it into, for example, the surrounding environment. The configuration of the liquid cooling circuit depends on various factors, such as the thermal load of the computing units, the available space and weight constraints, and the operating conditions. For example, the arrangement according to the embodiment may comprise the cooling plate, a pump which is used to circulate the fluid through the cooling circuit. The pump can be either electrically or thermally driven, depending on the available power sources and space constraints. Furthermore, a radiator is used to dissipate the heat carried by the fluid into the surrounding environment. The radiator typically consists of a series of thin fins through which air flows, transferring heat from the fluid to the ambient air. A thermostat is used to control the temperature of the fluid and ensure that it stays within the desired operating range. The thermostat can be either mechanically or electronic, depending on the required precision and response time. A reservoir is used to store excess fluid and ensure that there is always enough fluid in the circuit. The reservoir can also provide a convenient location for filling and draining the circuit during maintenance.

Another aspect of the invention relates to a calculating unit for an electronic computing device comprising a cooling plate according to the preceding aspect or an arrangement according to the preceding aspect and at least one, in particular, at least two, preferably at least three, computing units arranged on a respective side of the cooling plate. As already mentioned, the computing units are in particular configured as so-called printed circuit boards, (PCB).

According to an embodiment of the calculating unit, at least one computing unit is connected at least in part via a heat conducting element to the cooling plate. For example, at least one power element of the computing unit is connected via a pedestal of the cooling plate to the cooling fluid. Between the pedestal and the power element may also be the heat conducting element for example, a heat conducting paste or a heat conducting pad. Therefore, a thermal connection between the power element and the fluid is provided. Therefore, the heat of the power element can be dissipated in an improved manner.

Another aspect of the invention relates to an electronic computing device comprising at least a calculating unit according to the preceding aspect and at least one housing, wherein the calculating unit is arranged inside that housing.

Furthermore, the present invention relates to a motor vehicle comprising at least the electronic computing device according to the preceding aspect. The motor vehicle is preferable at least in part automated or fully automated operated.

Advantageous embodiments of the cooling plate are to be regarded as advantageous embodiments of the arrangement, the calculating unit, the electronic computing device as well as the motor vehicle.

In particular, a computing unit can include one or more computers, one or more microcontrollers and/or one or more integrated circuits, for example one or more application-specific integrated circuits, ASIC, one or more field-programmable gate arrays, FPGA, and/or one or more systems on a chip, SoC. The computing unit can also include one or more processors, for example one or more microprocessors, one or more central processing units, CPU, one or more graphics processing units, GPU, and/or one or more signal processors, in particular one or more digital signal processors, DSP. The computing unit can also include a physical or virtual cluster of computers or others of the mentioned units.

A computing unit can also include one or more hardware and/or software interfaces and/or one or more storage units. Therein, a storage unit can be designed as a volatile data memory, for example as a dynamic random access memory, DRAM, or static random access memory, SRAM, or as a non-volatile data memory, for example as a read-only memory, ROM, as a programmable read-only memory, PROM, as an erasable programmable read-only memory, EPROM, as an electrically erasable programmable read-only memory, EEPROM, as a flash memory or flash EEPROM, as a ferroelectric random access memory, FRAM, as a magnetoresistive random access memory, MRAM, or as a phase-change random access memory, PCRAM.

Advanced Driver-Assistance Systems (ADAS) according to this invention are sophisticated electronic systems designed to enhance vehicle safety and driver convenience. These systems consist of various technical components, including sensors, cameras, radar, lidar, actuators, and control units. Sensors play a crucial role in detecting the environment around the vehicle. They include ultrasonic sensors, cameras, radar, and lidar. Ultrasonic sensors use sound waves to measure distances to nearby objects, while cameras capture images of the road and surrounding area. Radar and lidar use radio or light waves, respectively, to detect objects at longer ranges and with higher precision. ADAS control units/electronic computing device process sensor data and make decisions based on that information. They typically consist of a microcontroller, memory, input/output interfaces, and communication protocols. The control unit receives data from the sensors, processes it using algorithms and machine learning techniques, and then sends commands to the actuators to take appropriate actions. Actuators are devices that convert electrical signals into physical movements or actions. They include electric motors, solenoids, and hydraulic or pneumatic systems. For example, an electric motor can adjust the steering angle, while a solenoid can control the brakes or throttle position. A user interface provides feedback to the driver about the status of the ADAS. It includes visual displays, audible alerts, and haptic feedback. Visual displays show information on dashboard screens, while audible alerts use sounds or voice messages to warn the driver of potential hazards. Haptic feedback can include steering wheel vibrations or seat pulses to alert the driver of danger. ADAS rely on communication protocols to transmit data between components. Common protocols include CAN (Controller Area Network), LIN (Local Interconnect Network), and Ethernet. These protocols allow different components to communicate with each other, ensuring that the ADAS functions as intended. Modern ADAS use machine learning algorithms to improve their performance over time. These algorithms analyze sensor data and learn from it, allowing the system to adapt to changing conditions and improve its accuracy. In summary, an ADAS consists of various technical components, including sensors, control units, actuators, user interfaces, communication protocols, and machine learning algorithms. By combining these elements, ADAS can help improve vehicle safety, reduce accidents, and enhance the driving experience.

Further features of the invention are apparent from the claims, the figures and the description of figures. The features and feature combinations mentioned above in the description as well as the features and feature combinations mentioned below in the description of figures and/or shown in the figures can be encompassed by the invention not only in the respectively specified combination, but also in other combinations. In particular, implementations and feature combinations can also be encompassed by the invention, which do not comprise all of the features of an originally formulated claim. Moreover, implementations and feature combinations can be encompassed by the invention, which extend beyond or deviate from the feature combinations set forth in the relations of the claims.

Therefore, the figures show in:
- Fig. 1: A schematic side view according to an embodiment of a motor vehicle comprising an embodiment of an assistance system comprising an embodiment of an electronic computing device;
- Fig. 2: a schematic perspective view according to an embodiment of an electronic computing device;
- Fig. 3: a schematic explosive view according to the electronic computing device from Fig. 2;
- Fig. 4: a schematic cross-sectional view of the electronic computing device according to the Fig. 2 and 3;
- Fig. 5: a schematic perspective view according to an embodiment of a cooling plate of an electronic computing device
- Fig. 6: another schematic view according to an embodiment of the cooling plate according to Fig. 5;
- Fig. 7: two perspective views according to an embodiment of the cooling plate according to Fig. 5 and 6;
- Fig. 8: a schematic perspective view according to another embodiment of an electronic computing device; and
- Fig. 9: a schematic cross-sectional view of the electronic computing device according to Fig. 8

In the Figures, the same elements are comprising the same reference signs.

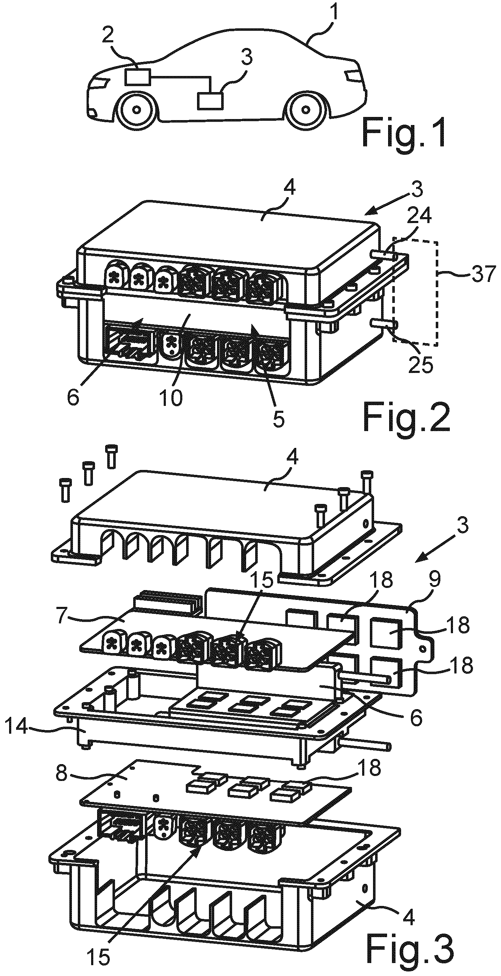

Fig. 1 shows a schematic side view according to an embodiment of a motor vehicle 1. The motor vehicle 1 is at least in part automatically operated or fully automatically operated. The motor vehicle 1 may comprise at least an assistance system 2, in particular for operating the motor vehicle 1 in the at least in part automated form.

The assistance system 2 or the motor vehicle 1 may comprise at least one electronic computing device 3. The electronic computing device 3 is in particular configured for calculation tasks for the motor vehicle 1 and/or the assistance system 2.

Fig. 2 shows a schematic perspective view according to an embodiment of the electronic computing device 3. As shown in Fig. 2, the electronic computing device 3 comprises at least one housing 4, wherein inside the housing 4 at least in part and calculating unit 5 is arranged. The calculating unit 5 may at least comprise an arrangement 6 wherein the arrangement 6 is configured for tempering at least one computing unit 7, 8, 9 (Fig. 3) of the electronic computing device 3, and wherein the arrangement 6 comprises at least a cooling plate 10 as well as at least one temperature control unit 37.

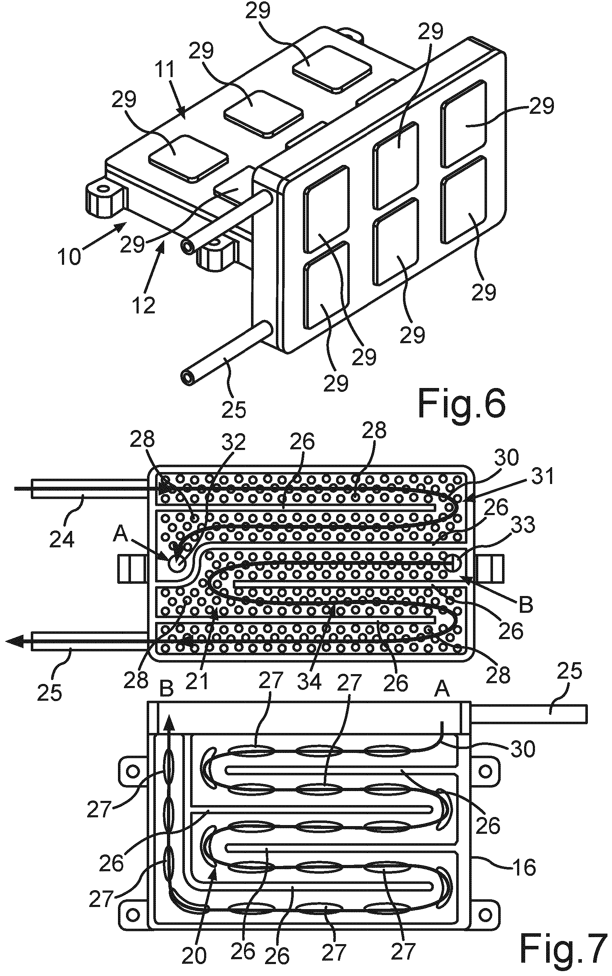

Fig. 3 shows a schematic perspective view according to the embodiment of the electronic computing device from Fig. 2 in an explosive view. In particular, it is shown, that at least 3 computing units 7, 8, 9 are arranged on the cooling plate 6. In particular, on a first side 11 (Fig. 6) of the cooling plate 6, a first computing unit 7 is arranged. At a second side 12 (Fig. 6), a second computing unit 8 is arranged. At a third side 13 (Fig. 6), a third computing unit 9 is arranged.

Furthermore, Fig. 3 shows a so-called middle housing 14, wherein the middle housing 14 may at least in part comprise the second side 12. Furthermore, Fig. 3 shows, that a plurality of sockets 15 may be arranged at the computing units 7, 8, 9. The computing units 7, 8, 9 may in particular be configured as so-called printed circuit boards (PCB).

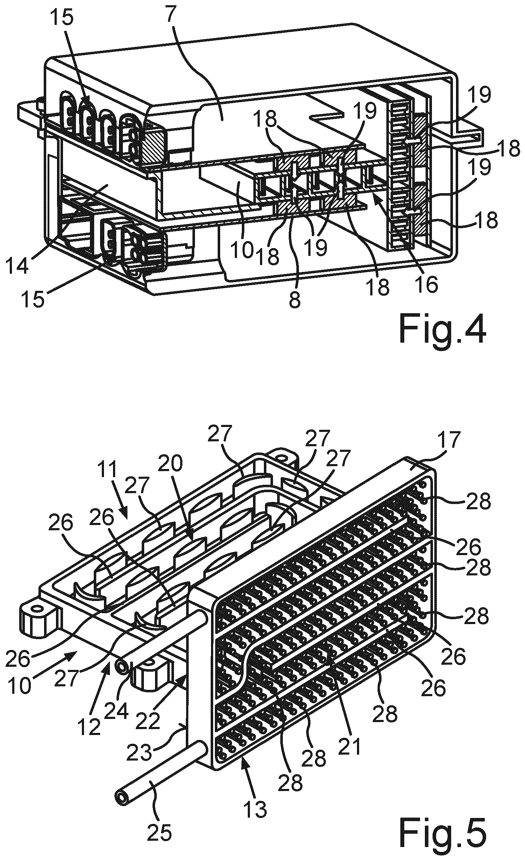

Fig. 4 shows a schematic cross-sectional view of the electronic computing device 3 according to the Fig. 2 and 3. Fig. 4 shows in particular the cooling plate 10, wherein the cooling plate 10 comprises at least a first cooling plate element 16 and a second cooling plate element 17. Furthermore, it is shown, that at the computing unit 7, 8, 9 power elements 18 are provided. The power elements 18 generate heat during an operation, and the heat is dissipated via the cooling plate 10. The heat transfer from the power elements 18 to the cooling plate 10 is shown via arrows 19.

Fig. 5 shows a perspective view according to the embodiment of the cooling plate 10. As already mentioned, the cooling plate 10 comprises at least the first cooling plate element 16 and the second cooling plate element 17.

According to an embodiment, the cooling plate 10 is configured for tempering at least the one computing unit 7, 8, 9 of the electronic computing device 3. The first cooling plate element 16 comprises a first cavity 20 for receiving a fluid from the temperature control unit 37, wherein the first cooling plate element 16 is plate-like formed, and comprises the first side 11 for arranging the first computing unit 7 and the second side 12, which is arranged opposite to the first side 11, for arranging the second computing unit 8.

As shown, the cooling plate 10 comprises the second cooling plate element 17, wherein the second cooling plate element 17 comprises a second cavity 21 for receiving a fluid from the temperature control unit 37, wherein the second cooling plate element 17 is plate-like formed, wherein the second cooling plate element 17 comprises at least the third side 13 for arranging the third computing unit 9, and wherein the second cooling plate element 17 is arranged at right angles to the first cooling plate element 16.

In particular, as shown in Fig. 5, the second cooling plate element 17 comprises a middle area 20 in the middle of a fourth side 23 of the second cooling plate element 17, wherein the fourth side 23 is arranged opposite to the third side 13, wherein the first cooling plate element 16 and the second cooling plate element 17 are connected at the middle area 22.

Furthermore, as shown in Fig. 5, the cooling plate element 16, 17, in particular just one cooling plate element 16, 17, in particular as shown, the second cooling plate element 17, comprises one fluid inlet 24 and one fluid outlet 25 for providing the fluid for the first cooling plate 16 and the second cooling plate element 17. In particular, therefore, the first cavity 20 and the second cavity 21 are fluidically connected to each other.

Fig. 5 further shows, that the at least one cavity 20, 21 of the at least two cavities 20, 21 comprises one fluid guiding element 26. The at least one fluid guiding element 26 is at least in part meander-shaped arranged inside the cavity 20, 21. Furthermore, it is shown, that at least the one cavity 20, 21 may comprise one surface enlargement element 27, 28, wherein the at least one surface enlargement element 27, 28 has a fin-like structure 27 and/or a pole-like structure 28.

Fig. 6 shows another schematic perspective view according to an embodiment of the cooling plate 10, wherein the cavities 20, 21 are covered with, for example, aluminum covers. The aluminum covers according to the shown embodiment may comprise at least one pedestal 29. The pedestals 29 are configured for being in contact with the power elements 18.

Therefore, between the power elements 18 and the pedestal 29 also heat contacting elements, in particular a heat contacting paste, may be arranged.

In particular, the Fig. 2 to 6 show that the cooling plate 10 is configured as a T-plate. For example, two horizontal PCBs are thermally connected to the horizontal portion of the T-plate. Top and bottom PCB boards are attached to the top and bottom size of the cooling plate 10 respectively. The vertical PCB is attached to the back of the T-plate and it is electrically connected to the two horizontal PCBs with board-to-board connectors. That way, all three PCB boards are electrically connected for power and signal distribution.

High power components, in particular the power units 18, are facing to the cooling plate 10, and particularly to the cooling elements 16, 17 and thermal gaps between the parts are filled with thermal insulation material, such as thermal paste or thermal pads.

The T-plate is designed for manufacturability as well. It can be machined if samples are required or casted in high-volume scenarios. After the machining or casting process, channels have to be sealed with friction stir welded plates. The T-plate can be designed to work with any type of fittings, including SAE or VDA type quick-release fittings. Pedestals 29 that are brazed to the cooling plate 10 have material allowance that is machined to achieve required dimensional accuracy, surface roughness and flatness.

The heat transfer between the PCB board and the T-plate is in particular shown with the arrows 19 in Fig. 4. The heat generated by all PCB boards travels through layers of heatconducting elements and soak into the cooling channels where it is carried away by the fluid. Channels in the cooling plate 10 are designed in such a way that the fluid in the channel flows from the top to the bottom of the T-plate when the ECU, in particular the electronic computer device 3, is in horizontal orientation.

The cooling plate 10 as described has the T-shape, therefore it is called the T-plate. It combines vertical and horizontal channels providing cooling to a number of PCBs that are thermally attached to it. The T-plate presented in Fig. 5 shows casted fins in the horizontal channel and pins in the vertical channel. It is just an example as different heat dissipation features can be designed and manufactured in the channels.

After the main structure of the T-plate is manufactured, all channels have to be closed to ensure water-tightness. In order to achieve it, for example two aluminum plates, in particular the corresponding covers, are thermally bonded to the plate in a process of brazing, welding or others.

Both plates also have a braze pedestal 29 to ensure proper thermal contact between hot components, the heat conducting elements and the plate. Pedestals 29 on the underside of the first cooling plate element 16 are casted when the main cooling plate part is manufactured.

All pedestals 29 have material allowance for bracing process and are then machined to achieve required accuracy, flatness and surface finish. The coolant inlet 24 and the coolant outlet 25 fittings are thermally bonded to the casted plate. For the purpose of this invention, they are represented by straight pipes. However, any underfitting can be used for this application.

Fig. 7 shows a schematic perspective view of the cooling plate elements 16, 17. In particular, on the top side of Fig. 7, the second cooling plate element 17 is shown and in a down side, the first cooling element 16 is shown. Furthermore, a fluid flow 30 is shown. The fluid flows from the inlet 24 through a first part 31 of the second cooling plate element 17. The second cooling plate element 17 comprises a first opening 32. The first opening 32 is fluidically connected to the first cooling plate element 16. The fluid flows completely via the meander-shaped form of the fluid-guiding element 26 through the first cavity 20. After completely flowing through the first cavity 20, the fluid is backguided through a second opening 33 to a second part 34 of the second cooling plate element 17. After that, the fluid exits the second cooling plate element 17 via the outlet 25.

Therefore, as shown, the T- plate is designed to have the one inlet 24 and one outlet 25, so all the channels are connected to form one continuous loop. The fluid goes through the inlet 24, feeds the coolant into the cooling plate 10. It then flows through vertical plate channels and leaves the vertical plate through the first opening 32. It then flows through the channels in the horizontal plate and leaves it through the second opening 33. The coolant returns to the vertical plate and continues its flow through the remaining part of the channel and exits the plate via the outlet 25.

Another design variant with the T-plate may be that additional cooling features such as fins, pins, or turbolators that accelerate heat dissipation are used.

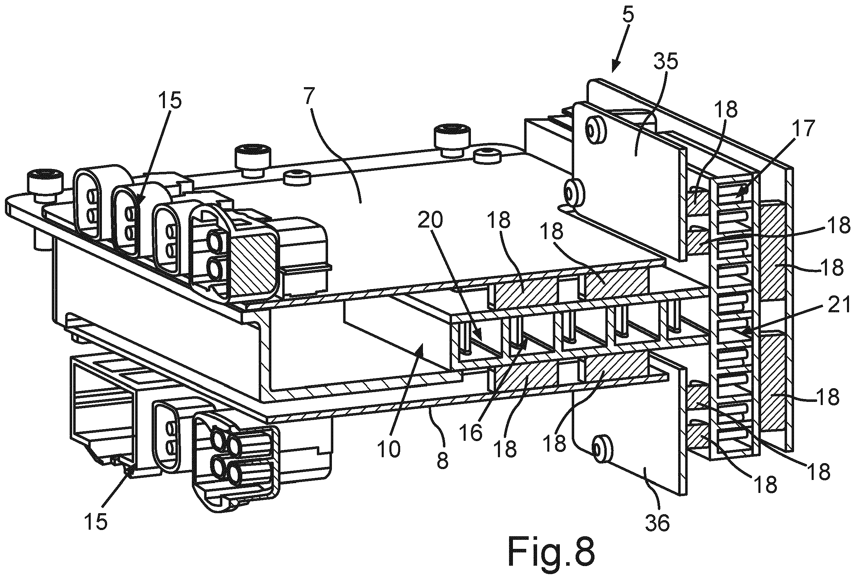

Fig. 8 shows another schematic perspective cross-sectional view according to embodiment of the calculating unit 5. The calculating unit 5 according to the embodiment comprises furthermore a fourth computing unit 35 and a fifth computing unit 36. As shown, the fourth computing unit 35 and the fifth computing unit 36 may also comprise power units 18. The power units 18 are then thermally connected, according to the shown embodiment, with the second cooling plate element 17.

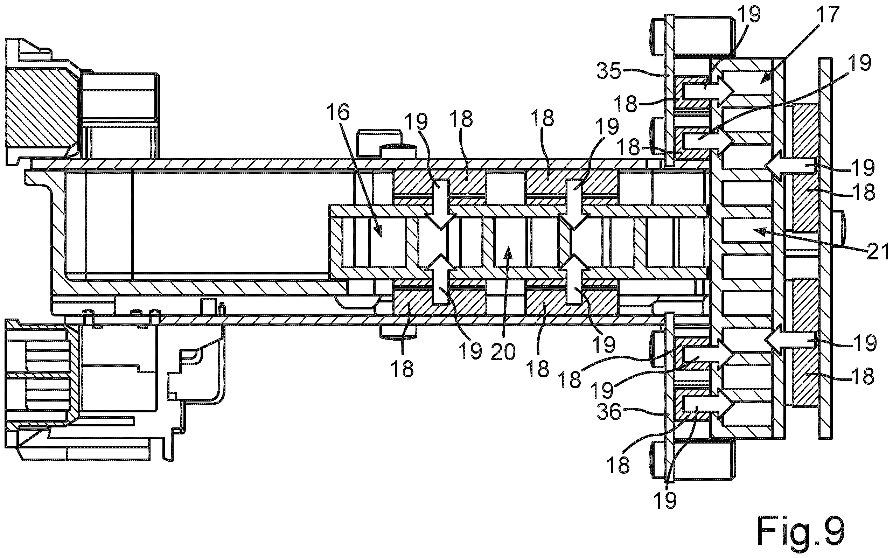

Fig. 9 shows a cross-sectional view according to the embodiment of Fig. 8. In particular, with arrows 19 the heat dissipation from the different power units 18 to the cooling plate 10 are shown. Therefore, the Fig. 8 and 9 shows variants of the T-plate with five PCBs being liquid cooled by the cooling plate 10. Again, all the PCB boards are connected with one another by board-to-board connectors. Variant with, for example, four computing units 7, 8, 9, 35, 36 is also possible, five PCB boards are the maximum number of PCBs that could be used with the shown design.

## Claims

1. A cooling plate (10) for tempering at least one computing unit (7, 8, 9, 35, 36) of an electronic computing device (3), comprising at least a first cooling plate element (16), which comprises a first cavity (20) for receiving a fluid from a temperature control unit (37) of the electronic computing device (3), wherein the first cooling plate element (16) is plate-like formed and comprises a first side (11) for arranging a first computing unit (37) and a second side (12), which is arranged opposite to the first side (11), for arranging a second computing unit (8),
**characterized in that**
the cooling plate (10) comprises a second cooling plate element (17), wherein the second cooling plate element (17) comprises a second cavity (21) for receiving a fluid from a temperature control unit (37), wherein the second cooling plate element (17) is plate-like formed, wherein the second cooling plate element (17) comprises at least a third side (13) for arranging a third computing unit (9), and wherein the second cooling plate element (17) is arranged at right angles to the first cooling plate element (16).

2. A cooling plate (10) according to claim 1,
**characterized in that**
the second cooling plate element (17) comprises a middle area (22) in the middle of a fourth side (23) of the second cooling plate element (17), wherein the fourth side (23) is arranged opposite to the third side (13), wherein the first cooling plate element (16) and the second cooling plate element (17) are connected at the middle area (22).

3. A cooling plate (10) according to claim 1 or 2,
**characterized in that**
the cooling plate elements (16, 17) comprises one fluid inlet (24) and one fluid outlet (25) for providing the fluid for the first cooling plate element (16) and the second cooling plate element (17).

4. A cooling plate (10) according to claim 3,
**characterized in that**
the first cavity (20) and the second cavity (21) are fluidically connected to each other.

5. A cooling plate (10) according to claim 2 and 4,
**characterized in that**
the second cooling plate element (16) comprises a first opening (32) in the middle area (22) for providing the fluid to the first cavity (20) and a second opening (33) for receiving the fluid from the first cavity (20).

6. A cooling plate (10) according to any one of claims 1 to 5,
**characterized in that**
at least in one cavity (20, 21) of the two cavities (20, 21) at least one fluid guiding element (26) is arranged.

7. A cooling plate (10) according to claim 6,
**characterized in that**
the at least one fluid guiding element (26) is at least in part meander shaped arranged inside the cavity (20, 21).

8. A cooling plate (10) according to any one of claims 1 to 7,
**characterized in that**
at least in one cavity (20 ,21) of the two cavities (20 ,21) at least one surface enlargement element (27, 28) is arranged.

9. A cooling plate (10) according to claim 8,
**characterized in that**
the at least one surface enlargement element (27, 28) has a fin-like structure (27) and/or the at least one surface enlargement element (27, 26) has a pole-like structure (28).

10. A cooling plate (10) according to any one of claims 1 to 9,
**characterized in that**
at least the first side (11) of the first cooling plate element (16) comprises at least one pedestal (29) for being thermally connected to a power element (18) of the first computing unit (7).

11. Arrangement (6) for tempering at least one computing unit (7, 8, 9, 35, 36) of an electronic computing device (3), comprising at least a cooling plate (10) according to any one of claims 1 to 10 and one a temperature control unit (37).

12. Calculating unit (5) for an electronic computing device (3) comprising a cooling plate (10) according to any one of claims 1 to 10 or one arrangement (6) according to claim 11 and at least one, in particular at least two, preferable at least three, computing units (7, 8, 9, 35, 36) arranged on a respective side of the cooling plate (10).

13. Calculating unit (5) according to claim 12,
**characterized in that**
the at least one computing unit (7, 8, 9, 35, 36) is connected at least in part via a heat conducting element to the cooling plate (10).

14. Electronic computing device (10) comprising at least the calculating unit (5) according to claim 12 or 13 and at least one housing (4).

15. Motor vehicle (1) comprising at least one electronic computing device (10) according to claim 14.
